Europäisches Patentamt

European Patent Office

Office européen des brevets

(19)

(11) Publication number: **0 043 654**
**A2**

# EUROPEAN PATENT APPLICATION

(21) Application number: **81302625.9**

(22) Date of filing: **12.06.81**

(51) Int. Cl.³: **H 01 L 29/91**

(30) Priority: **01.07.80 GB 8021448**

(43) Date of publication of application: **13.01.82**
**Bulletin 82/2**

(84) Designated Contracting States: **DE FR GB IT NL**

(71) Applicant: **The Secretary of State for Defence in Her Britannic Majesty's Government of The United Kingdom of Great Britain and, Northern Ireland Whitehall, London SW1A 2HB (GB)**

(72) Inventor: **Deadman, Harry Alexander, 19 Manor Close, Clifton Shefford Bedfordshire (GB)**
Inventor: **Sullivan, Arthur Basil Joseph, 12 Glebe Road, Letchworth Hertfordshire (GB)**
Inventor: **Vokes, John Charles, 11 Grasmere Avenue, Harpenden Hertfordshire (GB)**

(74) Representative: **Robinson, Frederick Robert et al, Procurement Executive Ministry of Defence Patents 1 A (4) Room 1932, 19th Floor Empress State Building, Lillie Road, London SW6 1TR (GB)**

(54) **Improvement in or relating to semiconductor diodes and their fabrication.**

(57)     The invention relates to semiconductor diodes for use at high frequencies.

The diode is designed to minimise series resistance and particularly spreading resistance which affects the spreading of current through the semiconductor body from a first to a second contact.

The inventive diode has a cylindrical or part cylindrical shape wiht the first contact in the form of a stripe along the cylinder axis surrounded by semiconductor body which in turn is surrounded by the second contact in the form of a cylindrical or part cylindrical shell.

An approximation to this form is a prismatic construction, the prism having either a trapezoidal or hexagonal cross section.

The current spreading from the first (1) to the second (3) contact thus has a substantially uniform distribution within the semiconductor body which comprises an active semiconductor portion (2b) and a high conductivity portion (2a).

The invention also includes methods for constructing such diodes.

Improvement in or relating to Semiconductor
Diodes and their Fabrication

This invention relates to semiconductor diodes, in particular to high frequency and microwave diodes, and to methods of fabricating such devices.

Conventional microwave diodes for application as mixers and detectors normally comprise a small area rectifying contact formed on the surface of an epitaxial active layer grown on a high conductivity substrate to which a relatively large area ohmic contact is made. To optimise the performance of such devices, it is desirable to minimise the series resistance of the device to obtain a high cut-off frequency and increased sensitivity. The series resistance is in effect the sum of three major contributions; the spreading resistance from the edge of the depletion region to the ohmic contact; the contact resistance between the ohmic metallisation and the semi-conductor material; and the resistance of the rectifying contact metallisation. There is also a small contribution from the ohmic contact metallisation itself, but this is generally very small in comparison to these three major contributions.

In order to reduce the spreading resistance in high frequency diodes of this kind, it is common practice to adopt a planar configuration in which the ohmic contact is made to the same surface of the high conductivity substrate to that on which the active layer is formed.

This enables the ohmic contact to be placed very close to the rectifying contact on the same surface of the substrate, thereby achieving a shorter current path between the depletion region and the ohmic contact than would be the case if the ohmic contact were disposed on the opposite surface of the substrate, as in conventional lower frequency diodes. In this way, path lengths as small as a few microns can be achieved, limited mainly by manufacturing tolerances.

Although this planar configuration does enable higher cut-off frequencies to be obtained by reducing the spreading resistance of the device, only limited improvements in performance can be achieved because current spreading from the rectifying contact to the ohmic contact within the substrate is largely confined to a relatively small spreading angle occupying a shallow surface region of the substrate. This gives rise to a non-uniform current distribution and represents a considerable departure from an idealised design.

According to a first aspect of the present invention, a semiconductor diode comprises a body of semiconductor material comprising a layer of active semiconductor material formed on a substrate portion of high-conductivity semiconductor material, a first contact formed on the surface of the active layer and a second relatively larger area contact forming an ohmic contact with the high-conductivity substrate portion of the semiconductor body, said substrate portion providing a low resistance path through which current flows between the first and second contacts in operation of the device, wherein the surface of the high conductivity substrate portion of the semiconductor body on which the ohmic second contact is formed is profiled to promote uniform current distribution within the substrate in operation of the device.

3

This may conveniently be achieved by providing a substantially uniform separation between the first and second contacts through the semiconductor body.

Optimisation of the design of devices in accordance with the present invention requires the ohmic second contact to be brought close to the first contact to reduce the series contribution of the semiconductor material separating them. However, as the second contact is brought closer to the first contact, its area necessarily becomes smaller for a given device geometry. Accordingly, the second contact may advantageously be separated from the first contact by a distance substantially equal to $\rho_c/\rho$, where $\rho_c$ is the specific resistance of the ohmic contact and $\rho$ is the resistivity of the semiconductor material in contact with the ohmic contact.

Preferably the first contact is of high aspect ratio, for example in the form of an elongate stripe having a high periphery to area ratio to facilitate spreading of current into the semiconductor body in operation of the devices. In this case, the profiled surface of the semiconductor body on which the ohmic second contact is formed, may be cylindrical or part cylindrical, or at least approximately so, and substantially coaxial with the elongated first contact.

In one form of device according to the present invention, the first contact is in the form of an elongated stripe disposed axially along the centre of the flat surface of a substantially semi-cylindrical body of semi-conductor material formed with an ohmic contact over its profiled surface. In such a device, current can spread out over an angle of approximately 180° from the rectifying contact to the ohmic contact, through the semiconductor body. This angle may be increased by arranging the elongate rectifying contact in a recess in

— 3

4

the flat surface of the semiconductor body. Alternatively, however this angle may be increased to a maximum ($360^\circ$) by embedding the elongated stripe contact in a substantially cylindrical body of semiconductor material surrounded by an ohmic contact on its profiled outer surface.

Conveniently, the elongated first contact is fed from one or both ends, the latter being preferred as it reduces the resistance contribution of the contact metallisation of the first contact which may be significant where comparatively long narrow rectifying contacts are used.

Additionally or alternatively, an approximately $\underline{n}$-fold reduction in the resistance contribution of the first contact metallisation may be obtained, for a given overall contact length $\underline{l}$, by arranging a plurality $\underline{n}$ of shorter contacts each of length $\underline{l}/\underline{n}$ in parallel. In either case, a reduction in the metallisation resistance of the first contact can lead to an increase in the cut-off frequency of the device, particularly where comparatively long contact lengths are employed.

The invention may be applied to reduce the series resistance of any type of diode in which at least one of the contacts is an ohmic contact, for example, mixer and detector diodes, varactor diodes and impatt diodes, in which the first contact comprises a rectifying junction contact, and transferred electron (Gunn) effect diodes in which both the first and second contacts are ohmic contacts.

It will be apparent that for best results, the separation between the first and second contacts of devices in accordance with the invention must be very much smaller than in conventional non-planar devices, typically between 2 and 20 microns. A novel fabrication technique is required which enables devices of the above kind to be made with their

5

contacts separated by such small thicknesses of
semiconductor material, particularly at the smaller
end of the range.

According to a second aspect of this present
invention, a method of fabricating a semiconductor diode
of the above kind comprises forming the layers of
semiconductor material from which the device body is to
be formed on the surface of a temporary substrate,
applying an appropriate one of the two device contacts
to the surface of the exposed semiconductor layer,
applying a permanent support substrate to this surface
overlying the contact, removing the temporary substrate,
and applying the other device contact to the thus exposed
surface of the other layer of semiconductor material, the
surface of the semiconductor layer to which the larger area
ohmic contact of the device is applied being profiled as
aforesaid before application of the contact thereto.

The surface of the semiconductor layer to which
the ohmic second contact of the device is applied, ie the
high conductivity layer, may be profiled by using a
suitable material removing treatment, such as anisotropic
etching or ion milling, to remove the surrounding regions
of this layer, and conveniently also of the underlying
active layer, to define the profiled semiconductor device
body.

According to a preferred version of this method,
the two semiconductor layers from which the device body
is to be profiled are formed epitaxially on the surface of
the support substrate, the high conductivity layer being
formed on top of the active layer, and surrounding portions
of at least the high conductivity layer are then removed to
define the profiled semiconductor body surface to which the
ohmic second contact is applied over substantially the whole of the profiled surface. Following application of the permanent support substrate overlying this ohmic contact and removal of the temporary substrate, the said first contact of the device is then formed on the thus exposed surface of the active layer of the semitonductor device body.

Preferably the said first device contact is in the form of an elongate stripe and the semiconductor body is substantially semi-cylindrical, the elongate stripe electrode extending substantially along the axis of symmetry of the semiconductor body. Orientation-selective etching of the semiconductor layer may conveniently be used to define the semiconductor body having a substantially trapezoidal cross-section approximating the ideally semi-circular cross-section. Alternatively any suitable form of material-removing treatment capable of achieving the required geometry may be used, for example ion milling.

In one form of device in accordance with the invention, the angle through which current from the rectifying contact can spread towards the ohmic contact in use, is increased by forming the rectifying contact in a recess in the semiconductor body.

According to a further aspect of the present invention, a method of fabricating a semiconductor diode in accordance with the first aspect of the present invention comprises forming the contact metallisation for the device first contact in the form an elongate stripe directly on the surface of a substrate, forming a layer of active semiconductor material followed by a layer of high conductivity semiconductor material on the surface of the temporary substrate and overlying the elongate stripe metallisation of the device first contact such that this metallisation forms the required contact with the active layer, removing surrounding portions of at least the high conductivity layer to define eg a substantially cylindrical profiled semiconductor body having a profiled surface substantially uniformly separated from the elongate stripe contact, and forming an ohmic contact over the profiled surface of the high conductivity layer to define the device second contact.

Additionally, a permanent support substrate may then be applied to the structure over the ohmic second contact of the device, and the original substrate removed to expose the elongate stripe first contact.

Yet further fabrication steps may then be used to form an additional active semiconductor layer followed by a high conductivity semiconductor layer over the exposed elongate stripe contact, followed by profiling of at least the high conductivity layer to define a second substantially semi-cylindrical device body portion which complements the first to produce a substantially cylindrical body surrounding the central stripe contact, and finally formation of an ohmic contact over the profiled surface of the second substantially semi-cylindrical body portion.

This latter construction provides a device in which current can spread out through 360° between the central stripe contact and the surrounding ohmic contact.

In those fabrication processes in which the original or temporary substrate is removed following application of a permanent support substrate, removal of the temporary substrate may be effected by any suitable technique, advantageously by preferential etching using an etching process either which does not affect the adjacent semi-conductor layer or which removes the temporary substrate material immediately adjacent to the semi-conductor layer at a faster rate than it attacks the semiconductor layer.

8

Preferably the temporary substrate comprises a first relatively thick layer of semiconductor material formed with relatively thin buffer layer of semiconductor material of a different type, the device semiconductor layer or layers then being grown on the surface of the buffer layer. Removal of the substrate may then comprise removal of the first substrate layer against the buffer layer using a selective etching technique, followed by removal of the buffer layer against the device semiconductor body layer by a second selective etching technique. The selective etching techniques may be electro-chemical, chemical or a combination of both.

In a preferred method, the device semiconductor body layers comprise GaAs epitaxially grown on the surface of a temporary substrate which comprises a relatively thick first layer of GaAs on which is formed a relatively thin epitaxial buffer layer of GaAlAs, the temporary substrate being removed by a combination of two selective etching techniques.

Conveniently the support substrate may be applied by first forming on the surface of the structure supported by the temporary substrate, a thin coating of insulating material, and then bonding the supporting substrate to the coating, for example using an adhesive. The coating may conveniently comprise a polyimide. Because the support substrate is isolated from the device structure by an insulating coating, the support substrate may be of any suitable material, preferably having a low dielectric constant.

Further, in devices fabricated by a method in accordance with the present invention, because the temporary substrate is removed during the fabrication process, its properties are irrelevant to the subsequent operation of the device, and a wider range of starting substrate materials than have hitherto been conventionally employed, may be used.

9

Other details and advantages of the present invention will become apparent from the following description of preferred devices and methods of fabricating them, given by way of example only with reference to the accompanying drawings, in which:-

Figure 1 is a schematic perspective view of an optimum form of device in accordance with the present invention;

Figure 2 is a schematic cross-sectional view of a second form of device in accordance with the present invention;

Figures 3(a) to (d) illustrate various stages in a preferred fabrication procedure for the device shown in Figure 2;

Figure 4 is a schematic plan view of a device fabricated by the procedure illustrated in Figure 3;

Figures 5 to 7 are schematic plan views of various alternative forms of device in accordance with the invention;

Figure 8 is a schematic cross-sectional view along the line VIII - VIII of the device shown in Figure 7;

Figure 9 is a schematic cross-sectional view, on a larger scale, through a modified form of the device illustrated in Fig 2; and

Figures 10(a) - (f) illustrate various stages in the fabrication of a further form of device in accordance with the present invention.

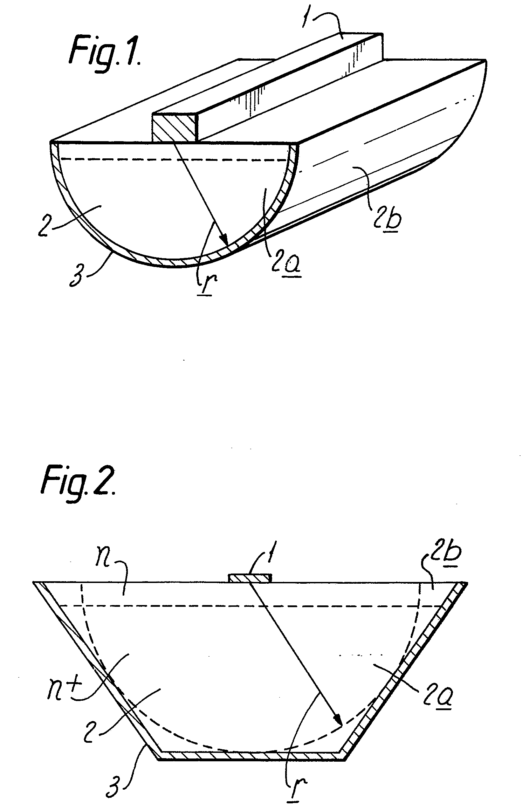

Referring to the drawings, Figure 1 represents an optimum design geometry for achieving minimum parasitic series resistance in high frequency, eg microwave diodes in particular mixer/detector diodes. This device comprises an elongated "stripe" rectifying contact 1 disposed axially along the flat surface of a semi-cylindrical semiconductor body 2

9.

comprising a main high conductivity $n^+$ layer 2a providing a substrate for a thin n-type active layer 2b, formed with an ohmic contact 3 over its curved surface. This geometry maximises the spread of current flow from the rectifying contact into the semi-conducting body. The parasitic series resistance for devices of this kind is composed of three contributions; the resistance of the ohmic contact; the spreading resistance within the semiconductor body 2 from the edge of the depletion region to the ohmic contact 3; and the resistance of the rectifying "stripe" contact 1 metallisation.

Ohmic contacts are characterised by a specific contact resistance $\rho_c$, the resistance of the contact being given by -

$$R = \rho_c/A$$

where A is the area of contact. The resistance contribution of the semiconductor body (resistivity $\rho$) is a function of the radial distance r between the rectifying and ohmic contacts of the device. As the distance r is reduced bringing the ohmic contact closer to the rectifying contact to reduce the spreading distance contribution, the resistance of the ohmic contact will consequently increase as its area decreases. For a given geometry therefore there is an optimum value for the distance r, and this is given approximately as

$$r_{opt} = \rho_c/\rho$$

It is however generally impractical to fabricate devices in which the semiconductor body has a precisely semi-cylindrical configuration, but the desired shape may conveniently be approximated by anisotropic etching to produce faceting on a suitably oriented semiconductor material as illustrated in Figure 2 for a GaAs device. Here the dotted line represents the desired semi-circular cross-section, while the actual cross-section of the device shown is produced by anisotropic etching of GaAs.

The above considerations apply generally to many types of high frequency diodes having an ohmic contact, for example, mixer and detector diodes, varactor diodes, impatts and transferred electron effect diodes. Conventionally in mixer and detector diodes, Schottky barrier contacts have been used to achieve the required mixer/detector action. However, it has been shown that a Mott barrier contact consisting of metal contact on a thin low doped active layer on a high conductivity substrate (eg n type GaAs on an $n^+$ GaAs substrate) which in operation is punched through even under small forward bias conditions, can give lower noise figures and lower turn-on voltages which makes it desirable for millimeter wave applications.

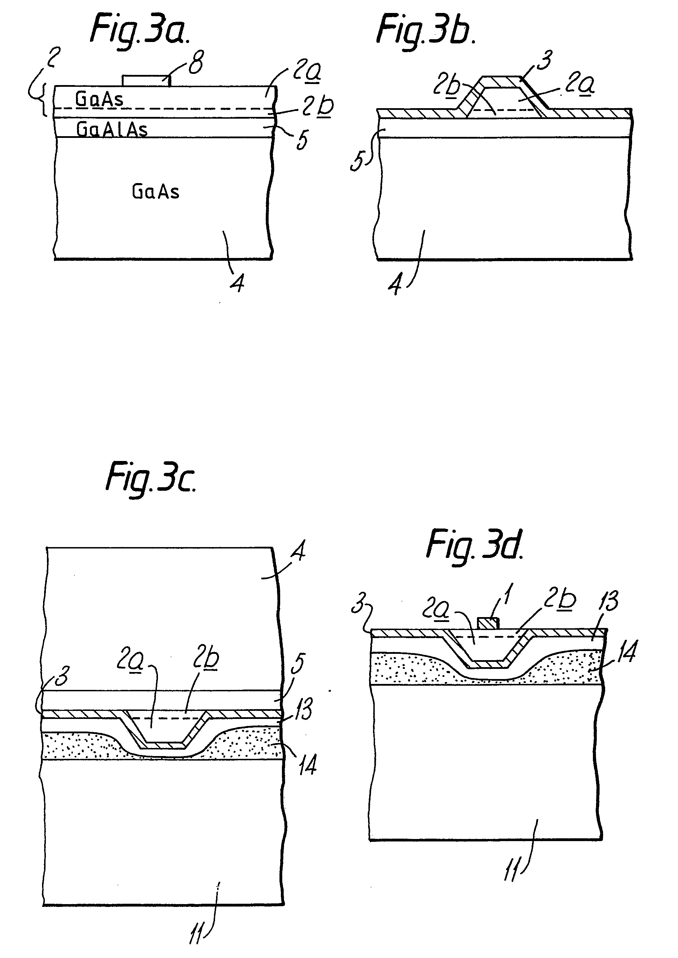

A method of fabricating a GaAs mixer/detector diode in accordance with the present invention, which is applicable to both Schottky barrier and Mott-type diodes, will now be described with reference to Figure 3. The fabrication procedure initially comprises forming a GaAlAs buffer layer 5 between 0.5 to 2 microns thick on the surface of a semi-insulating (SI) GaAs substrate 4, typically several hundred microns thick, and forming on the surface of the GaAlAs buffer layer 5, a layer 2 of GaAs comprising a first active n type layer 2b followed by the $n^+$ "substrate" layer 2a. The buffer layer 5 and the GaAs layer 2 are both formed epitaxially, eg by liquid or vapour phase, or molecular beam epitaxy.

Typically for a Schottky barrier diode the thickness of the GaAs active n layer 2b will be between 0.1 and 0.3 microns and have a dopant concentration between $5 \times 10^{16}$ and $2 \times 10^{17}$ carriers/$cm^3$. For an equivalent Mott-type diode, the GaAs n layer 2b is formed to a thickness of 0.1 to 0.2 microns, and a lower carrier concentration of between $5 \times 10^{15}$ and $2 \times 10^{16}$. In either case these parameters are chosen in accordance with conventional Schottky barrier and Mott diode design criteria. In both cases the $n^+$ substrate has a thickness of about 3 microns and a carrier concentration of about $2 \times 10^{18}$ per $cm^3$.

An etch mask is then formed on the surface of the n+-type GaAs layer $2\underline{g}$ comprising a patch of masking material 8 the dimensions of which are appropriately selected to produce the required GaAs body (2 in Figure 2). The structure at this stage is shown in Figure 3(a).

The exposed regions of the GaAs layer $2\underline{a}$ and underlying layer $2\underline{b}$ are then etched away using an orientation-selective etchant, such as a 90:5:5 mixture of $H_2O$, 100V $H_2O_2$ and 35% $NH_4OH$. By aligning the etch mask with an appropriate cleavage plane in the GaAs material which will normally be grown on the 100 plane, an approximately semi-cylindrical shape having a cross-section substantially as shown will be produced.

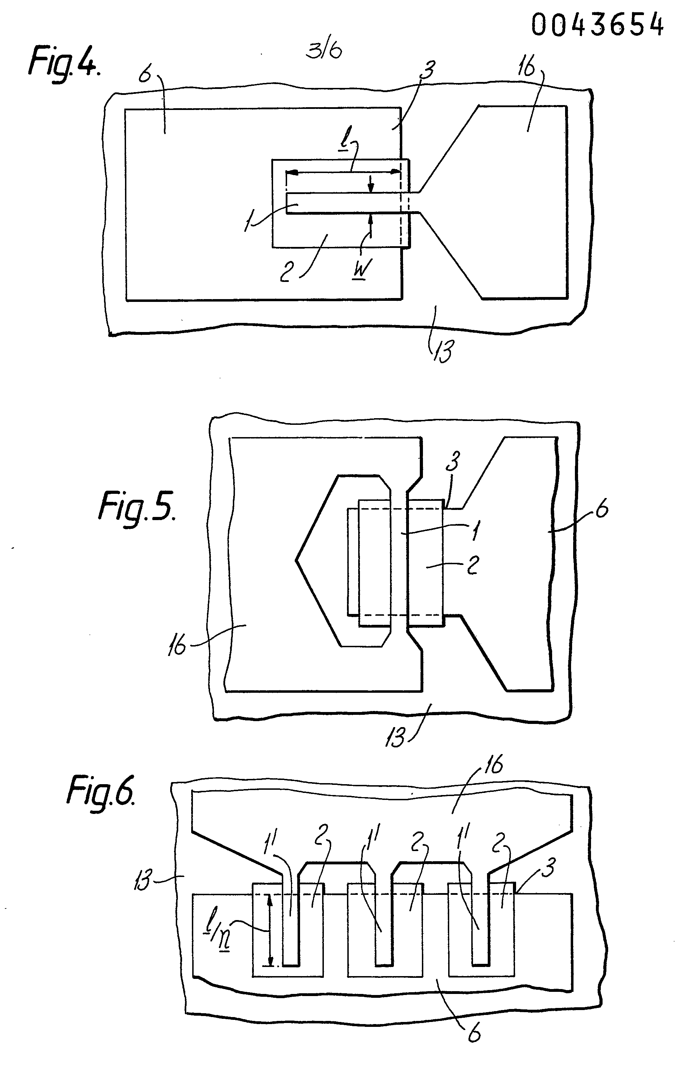

The etch mask is then removed, and an ohmic contact 3 is formed in conventional manner overlying substantially the whole of the exposed surface of the GaAs layer $2\underline{a}$ thus formed, apart from a small section at least at one end, and extending onto the surface of the surrounding GaAlAs buffer layer at one, or both sides as shown. This provides a contact pad 6 for external connection to the completed device (see Figure 4). The structure at this stage is shown in Figure 3(b).

Following formation of the ohmic contact 3 a support substrate 11 is applied to the surface of the structure overlying the ohmic contact. This support substrate 11 can be applied using any suitable low temperature technique which does not adversely affect the existing structure. One suitable technique used in the present example comprises the formation of an initial coating 13 of an insulating material on the surface of the structure to which the support substrate is applied using a suitable adhesive.

13

One suitable insulating material for the coating 13, is polyimide, such as that sold under the name of KERIMID (Registered Trade Mark) 601 by Rhone Poulenc, a condensation type polymer resin. The resin which is sold in powdered form is dissolved in a solvent and applied to the surface of the existing structure which is then spun at high speed to achieve a uniform coating of the desired thickness. The solvent is then dried at a temperature of about $120^{\circ}C$ before curing at a temperature of about $240^{\circ}C$ to give a hardened coating. To provide a coating 13 of improved quality, it may be built up from a number of successively applied thinner layers (typically of submicron thickness), successive layers being cured before application of the next.

Any suitable adhesive 14 may then be used to affix the insulating support substrate 11 to the coating 13. For example an epoxy resin may be used or, as in the present embodiment, a similar polyimide material as the coating 13 which may be applied as a solution and then cured to form the bond. The support substrate 11 may suitably comprise alumina, glass or a plastics material. The device at this stage is shown in Figure 3(c).

The purpose of the support substrate 11 is to provide a mechanical support for the GaAs layers $2^a$, $2^b$ and the ohmic contact 3 associated with it, so that the original semi-conductor substrate 4 can be removed together with the buffer layer 5 exposing the surface of the active GaAs layer $2^b$. Removal of the original GaAs substrate 4 is effected using a selective etching procedure in which the GaAlAs buffer.

layer 5 provides a chemical stop for the etchant used in removing the GaAs substrate 4, following which the buffer layer is removed using an etchant to which the GaAs layer 2 is resistant. In this way the free surface of the GaAs layer 2 is opposite to that on which the ohmic contact 3 is formed, ie the surface of layer $2^b$, is exposed for further device fabrication procedures.

The original semi-insulating GaAs substrate 4 is removed using a 95:5 100 V $H_2O_2$, 35% $NH_4OH$ mixture which attacks GaAs at a much faster rate than it attacks GaAlAs, about 2 orders of magnitude for an Al content of 60%, causing the etch to stop abruptly at the GaAs/GaAlAs interface. The GaAlAs buffer layer 5 is then removed using a different etchant, a 50% solution of HF, which attacks the GaAlAs at a faster rate than it attacks GaAs, the rate again being dependent upon the proportion of Al in the GaAlAs layer, again about 2 orders of magnitude for $Ga_{0.4}Al_{0.6}As$. Because the buffer layer 5 is relatively thin, $\frac{1}{2}$ to 2 microns, and because of the high differential etch rates, its removal can be effected without affecting the uniformity of the GaAs layers $2^a$, $2^b$.

Following removal of the GaAlAs barrier layer 5, a small surface thickness of the exposed n-type GaAs material 2b may optionally be removed by etching to remove surface defects and impurities. An elongated stripe metallic electrode 1 is then formed extending axially along the centre of the exposed GaAs surface to form a metal-semiconductor junction in known manner. The stripe electrode 1 terminates at one end adjacent to but spaced from one edge of the exposed GaAs surface while its other end extends across the opposite edge of this surface onto the surrounding surface of the insulating coating 13 where it terminates in an enlarged contact portion 16 as shown in

Figure 4. The rectifying stripe contact 1 is isolated from the underlying ohmic contact 3 as it traverses this edge by a small section of the GaAs material 2 which overlaps the edge of the ohmic contact 3 as described earlier, and as shown in Figure 4.

In the present example the rectifying contact 1 is formed by evaporation of Ti/Pd/Au through a standard photolithographic mask, although any suitable alternative technique may be used.

The dimensions and aspect ratio, ie length to width ratio, of the stripe contact 1 are important criteria in determining the operating characteristics of the device.

The total series resistance $R_T$ of the device 1 is the sum of three major contributions, namely the contact resistance $R_C$ between the ohmic contact 3 and the $n^+$ GaAs material $2^a$; the metallisation resistance $R_M$ of the rectifying contact itself; and spreading resistance $R_S$ defined earlier. The value of $R_S$ can be reduced simply by increasing the length $l$ of the device 1, say by a factor F, in which case the contact resistance $R_C$ will reduce by the same factor. But increasing the length of the device by a factor F will also increase the capacity of the rectifying contact by the same factor, and so to maintain a fixed capacity for this contact, its width $w$ must simultaneously be reduced by the same factor F. As is well known, the capacity of the rectifying contact in mixer diodes of this kind determines the maximum operating frequency of the device, and is related to the area of the contact.

However, decreasing the width $w$ of the contact 1 by a factor F increases its metallisation resistance $R_M$ by the same factor, assuming the thickness of the contact remains the same. In optimising the design of a device having a given capacity, it is possible to select the dimensions $l$ and $w$ for the contact which minimise the total series resistance $R_T$, ie which produce approximately equal values for the metallisation resistance $R_M$ and the sum of $R_C + R_S$.

16

Advantageously, the metallisation resistance $R_M$ of the contact 1 can be further reduced by contacting it from both ends as shown in Figure 5. For a contact 1 having a given length $\underline{l}$ and width $\underline{w}$ the resistance $R_M$ is approximately reduced by a factor of 4 as compared with the single-end feed arrangement of Figure 4.

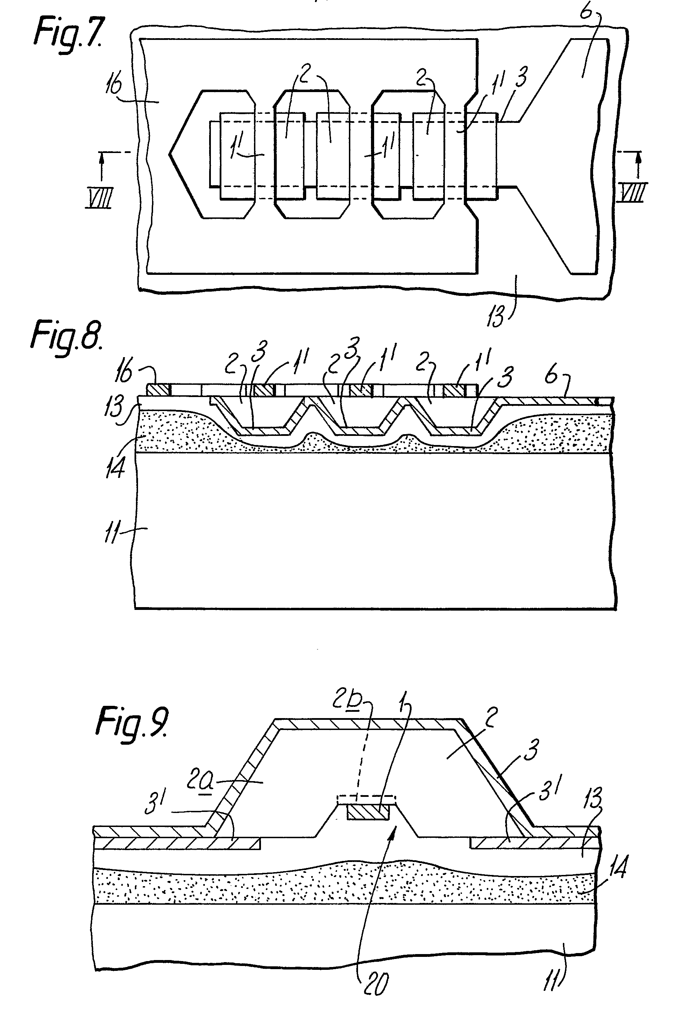

An alternative or additional way of reducing the metallisation resistance $R_M$ of a stripe contact 1 having a given total length $\underline{l}$ and width $\underline{w}$, is to divide it into a number $\underline{n}$ of smaller electrodes each of length $\underline{l/n}$, and to connect them in parallel as shown in Figure 6 for $\underline{n} = 3$. This effectively reduces the overall metallisation resistance $R_M$ of the $\underline{n}$ contacts by a factor of approximately $\underline{n}^2$ compared with the corresponding single electrode device shown in Figure 4. A consequence of dividing the electrode 1 into a number of shorter electrodes 1 connected in parallel in this way is that the total metallisation resistance of the ohmic contact 3 of the parallel connected devices will increase by up to approximately $\underline{n}^2$, depending on the exact design and in optimising the design of such an arrangement it is desirable to select a value of n such that the total metallisation resistance of the ohmic contacts 3 remains small or at least does not exceed any of the other resistance contributions.

The above two techniques for reducing the metallisation resistance $R_M$ of the stripe contact 1 can be combined as shown in Figure 7 for $\underline{n} = 3$. In this case the overall metallisation resistance of the contacts $1'$ is reduced by a factor of approximately $4\underline{n}^2$ compared with the single stripe contact 1 fed at one end as shown in Figure 4. Optimum design conditions for minimising the series resistance of the device for a given capacity are achieved when the overall value of the metallisation resistance $R_M$ is approximately equal to the sum of $R_S + R_C$, and when the overall resistance of the ohmic contact 3 remains small or at worst is comparable with these values.

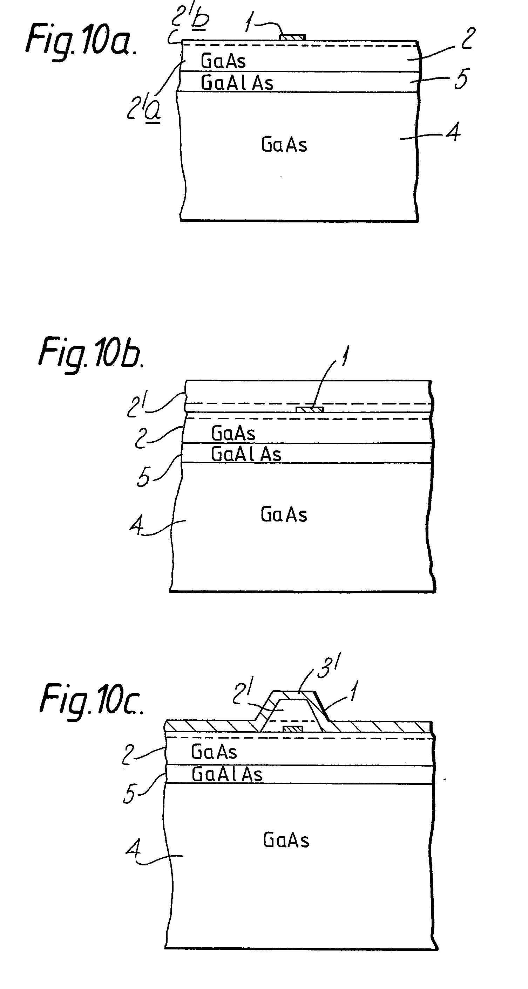

These design criteria apply in addition to that used in selecting the optimum value for the radius $r$ discussed earlier. A cross-section through the Figure 7 device, along the line VIII-VIII, is shown in Figure 8.

In each of the devices described so far, considerable reduction in the series resistance of the device is achieved by means of a stripe geometry for the rectifying contact 1 having a high aspect ratio in combination with a substantially semi-cylindrical semiconductor body configuration. This facilitates spreading of current into the semiconductor body 2 from the rectifying contact 1, whilst simultaneously providing a maximum area for the ohmic contact 3. In cross-section, current from the rectifying contact spreads out through approximately $\pi$ radians to the ohmic contact 3, but if this angle can be increased beyond $\pi$ radians then even lower resistances can be achieved.

The device shown in cross-section in Figure 9 illustrates one method of increasing the angle through which current spreads radially from the rectifying contact 1 to the ohmic contact 3. In this arrangement the rectifying contact 1 is recessed into the surface of the GaAs body 2, and to reduce the series resitance, an extra ohmic contact layer 3' may be applied as shown, extending onto the longitudinal edges of the flat surface of the semi-conductor body 2.

A preferred fabrication procedure for this type of device initially comprises forming, eg by epitaxial growth, a layer $2^a$ of high conductivity ($n^+$) semiconductor material on the surface of a temporary substrate (not shown) which may be the same as that used in the fabrication processed described above. The thickness of this high conductivity layer is slightly greater than the required radius $r$ of the device body, ie about 3.5 $\mu$m.

18

A photolithographic etching mask is then deposited on the surface of the high conductivity layer 2a having an elongated hole therein corresponding in length to the desired length of the rectifying first contact 1 of the device. A recess 20 is then formed in the layer 2a by anistropic etching through the mask to a depth of about 0.5 microns, and an active layer 2b is then formed in the $n^+$ material at the base of the recess 20 by ion implantation through the same mask followed by annealing. Tungsten metallisation for the rectifying stripe contact 1 is then deposited along the floor of the recess in contact with the active region 2b, and an ohmic contact metallisation 3' applied to the surface of the $n^+$ layer 2a along both sides of the recess 20, but spaced therefrom by a distance of about 1 to 1.5 $\mu$m. A permanent support substrate 11 is then applied to the structure as before, using a coating 13 and an adhesive 14, and the temporary substrate (not shown) is removed to expose the other side of the $n^+$ layer 2a. This is then profiled, as before, using an anistropic etching process to define a substantially cylindrical body axially aligned with the stripe contact 1. An ohmic contact metallisation 3 is then applied to the profiled surface of the $n^+$ layer 2a extending into contact with the previously applied ohmic contact metallisation 3' on either side of the device. The whole device is then heated to form an ohmic contact between the ohmic contact metallisation 3,3' and the $n^+$ region 2a of the device body.

19

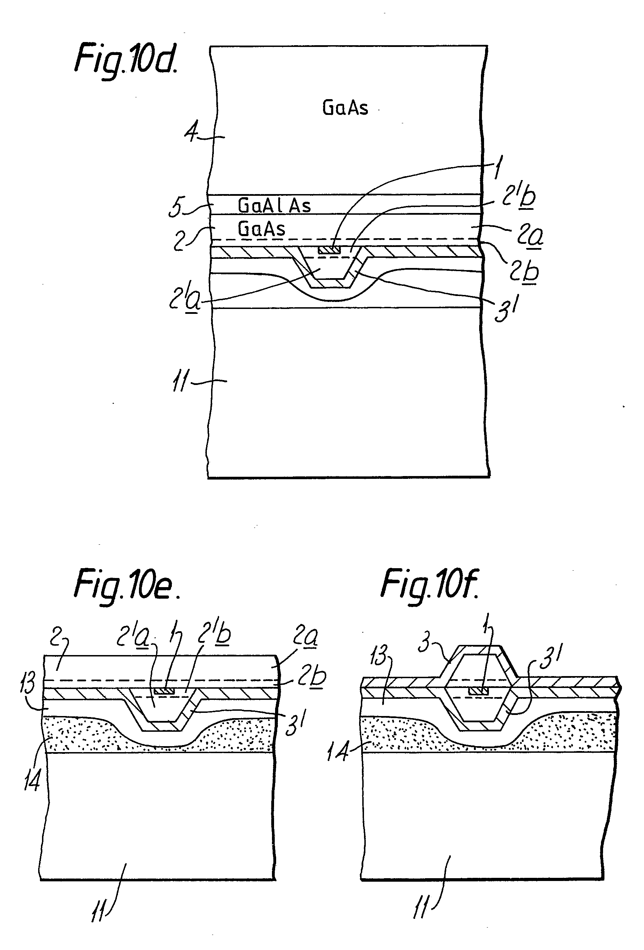

Figure 10 illustrates various stages in the fabrication of a further form of device in accordance with the present invention in which the angle through which current from the rectifying contact 1 can spread out through the GaAs body towards the ohmic contact 3, is extended to $2\pi$ radians. Referring first to Figure 10(a), the GaAlAs buffer layer 5 and n-type GaAs body layer 2 are epitaxially grown on the surface of a semi-insulating GaAs substrate 4 as before. The GaAs layer 2 consists of a high-conductivity $n^+$ GaAs substrate region 2a having a thin low-doped n-type active surface region 2b formed, for example, by ion implantation as before. A tungsten rectifying contact metallisation is then defined, using similar procedures to those described earlier to provide the narrow stripe rectifying contact 1, contacted at one or both ends by an enlarged contact pad portion (not shown) for single or double-end feed as appropriate.

A second layer 2' of GaAs material, equal in thickness to the first, is then grown epitaxially on the surface of the first GaAs layer 2. This involves growing an initial layer of $n^+$ GaAs having a thickness equal to the required thickness of the n type active region, selectively ion implanting the n type active region 2'b therein surrounding the stripe contact 1, and then completing the layer 2' by continued growth of $n^+$ material to a thickness equal to that of the first layer 2.

19

20

The formation of the second GaAs layer 2' on the surface of the first layer 2 such that the rectifying stripe contact 1 is embedded between the two layers involves a new technology developed for the fabrication of the permeable base transister described by C O Bozler et al in "Fabrication and Microwave performance of the Permeable Base Transistor" in the Conference Digest of IEDM, Washington DC December 1979.

This technique shows that when GaAs is epitaxially grown on a GaAs surface formed with a thin (about 100 Å) metallisation pattern in the form of a grid of a high melting point metal, such as tungsten, which does not react with the GaAs, then as the thickness of the grown GaAs increases, the material grows between the interstices of the grid and spreads over the metallisation pattern, eventually embedding it completely. A similar effect is achieved when the grid is replaced by a narrow metal stripe as in the present example, and the technique results in a rectifying metal-semiconductor junction between the epitaxially grown GaAs and the embedded metallisation. The resulting structure is shown in Figure 10(b), and it will be appreciated that only the narrow stripe portion 1 of the contact metallisation is embedded leaving the enlarged contact pad portion, (not shown) exposed.

The fabrication procedure then continues as in the process described with reference to Figure 3, with the orientation-selective etching of the upper GaAs layer 2' to define an approximate semi-cylindrical shape centred on the buried stripe electrode 1 which will provide one half of the GaAs body of the completed device. A metallisation layer 3' for the ohmic contact for this half of the device is then applied, but not annealed, as shown in Figure 10(c). A permanent support substrate 11, for example of alumina, is then applied to the surface of the structure which carries the ohmic metallisation $3'$ (Figure 10(d)), and the temporary GaAs substrate and GaAlAs buffer layer 5 are removed by selective etching using identical procedures to those described with reference to Figure 3. The structure at this stage is illustrated in Figure 10 (e). The GaAs layers $2,2'$ are both grown on the (100)plane, but only one of the layers may be anisotropically etched to produce the required cross-section, the other then being defined by an isotropic etching process, eg ion milling, which will achieve the required result.

Following this procedure to complete the cylindrical GaAs configuration, a further layer of ohmic contact metallisation 3 is then formed as shown in Figure 10(f), and the whole structure then annealed to optimise the ohmic contacts. The resulting device comprises a narrow rectifying metal stripe contact 1 at the centre of a cylinder of GaAs surrounded by an ohmic contact metallisation. Similar design criteria to those for the semi-cylindrical devices outlined earlier may also be applied in optimising the design of the cylindrical device. Furthermore the parallel connection of a number of single or double end fed cylindrical devices, as described with reference to Figures 6 to 8 for the semi-cylindrical configurations, may also be used to minimise the series resistance as before.

It will be noted, that the above described process of epitaxially growing semiconductor material over the narrow stripe contact 1 may also be used to form a device of semi-cylindrical configuration. For example, the metallisation for the stripe electrode may be formed directly on the surface of a suitable semi-insulating substrate, and the semiconductor layer required for the body of the device then epitaxially

22

grown onto this surface covering the narrow portion 1 of the contact, and forming a rectifying contact between them. The epitaxial layer is then profiled as before to define the required approximately semi-cylindrical body shape, followed by formation of the ohmic contact 3. The device configuration would then resemble that illustrated in Figure 10(c), except that the buffer layer 5 and lower semiconductor layer 2 would be omitted. Alternatively, the buffer layer may be retained, and the structure then applied to a permanent substrate followed by removal of the "temporary" semiconductor substrate 4 as before, to leave a device substantially as shown in Figure 10(e), but without the overlying semiconductor layer 2.

Although the invention has been described in its application to mixer and detector diodes fabricated from GaAs, it can equally be applied to other devices in particular varactor diodes or any diode having at least one ohmic contact, and the invention is of course not restricted to the use of this particular material. Further novel device configuration and fabrication techniques described may equally be applied to devices using other semiconductor materials such as Si, GaInAs or InP.

## CLAIMS

1    A semiconductor diode comprising a body of semiconductor material consisting of a layer of active semiconductor material formed on a substrate portion of high-conductivity semiconductor material, a first contact formed on the surface of the active layer  and a second relatively larger area contact forming an ohmic contact with the high-conductivity substrate portion of the semiconductor body, said substrate portion providing a low resistance path through which current flows between the first and second contacts in operation of the device, wherein the surface of the high conductivity substrate portion of the semiconductor body on which the ohmic second contact is formed is profiled to promote uniform current distribution within the substrate in operation of the device.

2    A semiconductor diode as claimed in claim 1 wherein the separation between the first and second contacts through the semiconductor body is arranged to be sufficiently uniform to promote uniform current distribution.

3    A semiconductor diode as claimed in claim 2 wherein the uniform separation is equal to $\ell c/\ell$ where $\ell c$ is the specific resistance of the ohmic contact $(\Omega m^{-2})$ and  $\ell$  is the resistivity of the semiconductor material in contact with the ohmic contact $(\Omega m^{-3})$.

4    A semiconductor diode as claimed in any of the previous claims wherein the first contact is of sufficiently high aspect ratio to facilitate current spreading during operation.

5    A semiconductor diode as claimed in claim 4 wherein the first contact comprises a strip and the second contact is disposed so as to form all or part of a prismatic shell with the first contact lying along the prism axis.

6    A semiconductor diode as claimed in claim 5 wherein the prismatic shell is a cylindrical shell.

7    A semiconductor diode as claimed in claim 5 wherein the prismatic shell is of hexagonal cross section.

8    A semiconductor diode as claimed in claim 6 or claim 7 wherein the shell covers an area such that, in cross section, it subtends an angle of $\pi$ radians at the axis.

9    A semiconductor diode as claimed in any of the previous claims wherein the first contact is a rectifying contact.

10    A semiconductor diode as claimed in any of the previous claims wherein conduction means is provided which connects the first contact at a plurality of points.

11    A plurality of semiconductor diodes according to any of the previous claims wherein, in addition, connection means is included to connect the diodes in a parallel array.

12    A method of fabricating a semiconductor diode according to claim 1 including:

    forming a layer of high conductivity semiconductor material on the surface of a temporary substrate,

    forming an active layer of semiconductor material on the surface of the high conductivity layer,

    applying the first diode contact to the surface of the active layer,

    overlaying the active layer and first contact with a support substrate,

    removing parts of at least the exposed high conductivity layer to give the required profile of the high conductivity portion of the semiconductor body of the diode,

    and forming the ohmic second contact over the profiled high conductivity portion.

13   A method of fabricating a semiconductor diode according to claim 1 including:

forming an active layer of semiconductor material on the surface of a temporary substrate,

forming a layer of high conductivity semiconductor material on the surface of the active layer,

removing parts of at least the high conductivity layer to give the required profile of the high conductivity portion of the semiconductor body of the diode,

forming the ohmic second contact over the profiled high conductivity portion,

overlaying the ohmic contact with a support substrate,

removing the temporary substrate,

and forming the first contact on the exposed surface of the active layer.

14   A method as claimed in either of claims 12 or 13 wherein a recess is formed in the active layer of semiconductor prior to formation of the first contact and the first contact is then formed in the recess.

15   A method of fabricating a semiconductor diode according to claim 1 including:

forming the diode first contact on the surface of a first substrate,

forming a layer of active semiconductor material on the surface of the first substrate and covering the first contact,

forming a layer of high conductivity semiconductor material on the surface of the active layer,

removing parts of at least the high conductivity layer to give the required profile of the high conductivity portion of the semiconductor body of the diode,

forming the ohmic second contact over the profiled high conductivity portion,

and overlaying the ohmic contact with a support substrate.

16    A method as claimed in claim 15 wherein the first substrate constitutes a temporary substrate and, following application of the support substrate, the temporary substrate is removed.

17    A method as claimed in claim 16 including the further steps of:

forming an additional layer of active semiconductor material over the first contact after removal of the temporary substrate,

forming an additional layer of high conductivity semiconductor material on the surface of the additional active layer,

removing parts of at least the additional high conductivity layer to provide a profiled high conductivity portion of semiconductor body over the first contact which is complementary to that underneath the first contact, thereby surrounding the first contact,

and forming an additional ohmic second contact over the profiled additional profiled high conductivity portion.

18    A method of fabricating a semiconductor diode according to any of claims 12-17 wherein the parts of high conductivity layer removed to profile the body of the diode are removed by anisotropic etching.

19    A method as claimed in claim 17 wherein the two high conductivity layers are etched so as to produce semiconductor body sections having trapezoidal cross sections which together give a semiconductor body of hexagonal cross section.

20    A method as claimed in any of claims 12-19 except claim 15 wherein the temporary substrate is removed by preferential etching using an etch which attacks the temporary substrate without substantially attacking the adjacent diode layer.

21    A method as claimed in any of claims 12-19 wherein the temporary or first substrate comprises an upper relatively thin high quality epitaxial buffer layer overlying a relatively thick lower semiconductor layer.

22    A method as claimed in claim 21 when dependent upon claims 12-14 and 16-19 wherein the temporary substrate is removed by etching using a first etch which etches the lower semiconductor layer without substantially attacking the buffer layer and a second etch which etches the buffer layer without substantially attacking the adjacent diode layer.

23    A method as claimed in claim 21 wherein the diode active semiconductor and high conductivity layers comprise GaAs, and the temporary or first substrate comprises a relatively thin buffer layer of GaAlAs overlying a relatively thick lower layer of GaAs.

24    A semiconductor diode or diode array substantially as herein described with reference to the accompanying drawings.

Fig.1.

Fig.2.

Fig.3a.

Fig.3b.

Fig.3c.

Fig.3d.

0043654

**Fig.4.**

**Fig.5.**

**Fig.6.**

Fig.7.

Fig.8.

Fig.9.

0043654

**Fig. 10a.**

2'b  1
2'a  2  GaAs
5  GaAlAs
4  GaAs

**Fig. 10b.**

1
2'
2  GaAs
5  GaAlAs
4  GaAs

**Fig. 10c.**

3'  1
2'
2  GaAs
5  GaAlAs
4  GaAs

Fig.10d.

Fig.10e.

Fig.10f.